# EUROPEAN PATENT SPECIFICATION

(11) **EP 1 498 781 B1**
(45) Date of publication and mention of the grant of the patent: **17.04.2019**
(21) Application number: 04254057.5
(22) Date of filing: 07.07.2004
(51) Int. Cl.: G03F 7/20

(54) **Immersion lithographic apparatus and device manufacturing method**
Lithografisches Immersionsgerät und Verfahren zur Herstellung einer Vorrichtung
Appareil lithographique par immersion et méthode de fabrication d'un dispositif

(30) Priority: 16.07.2003 EP 03254466
(43) Date of publication of application: 19.01.2005
(73) Proprietor: ASML Netherlands B.V., 5504 DR Veldhoven (NL)
(72) Inventor: Streefkerk, Bob, 5038 PE Tilburg (NL); Derksen, Antonius Theodorus Anna Maria, 5623 CB Eindhoven (NL); Lof, Joeri, 5616 BW Eindhoven (NL); Simon, Klaus, 5655 CP Eindhoven (NL); Straaijer, Alexander, 5644 KK Eindhoven (NL)
(74) Representative: Corcoran, Gregory Martin Mason

(56) References cited:
- EP-A- 0 605 103
- EP-A1- 1 628 330
- WO-A-99/49504
- US-A- 5 142 132
- US-A- 5 402 224

## Description

### Field

The present invention relates to an immersion lithographic apparatus and a method for manufacturing a device.

### Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

It has been proposed to immerse the substrate in the lithographic projection apparatus in a liquid having a relatively high refractive index, e.g. water, so as to fill a space between the final element of the projection system and the substrate. The point of this is to enable imaging of smaller features since the exposure radiation will have a shorter wavelength in the liquid. (The effect of the liquid may also be regarded as increasing the effective NA of the system and also increasing the depth of focus.) Other immersion liquids have been proposed, including water with solid particles (e.g. quartz) suspended therein.

However, submersing the substrate or substrate and substrate table in a bath of liquid (see for example US 4,509,852) means that there is a large body of liquid that must be accelerated during a scanning exposure. This requires additional or more powerful motors and turbulence in the liquid may lead to undesirable and unpredictable effects.

One of the solutions proposed is for a liquid supply system to provide liquid on only a localized area of the substrate and in between the final element of the projection system and the substrate using a liquid confinement system (the substrate generally has a larger surface area than the final element of the projection system). One way which has been proposed to arrange for this is disclosed in WO 99/49504.

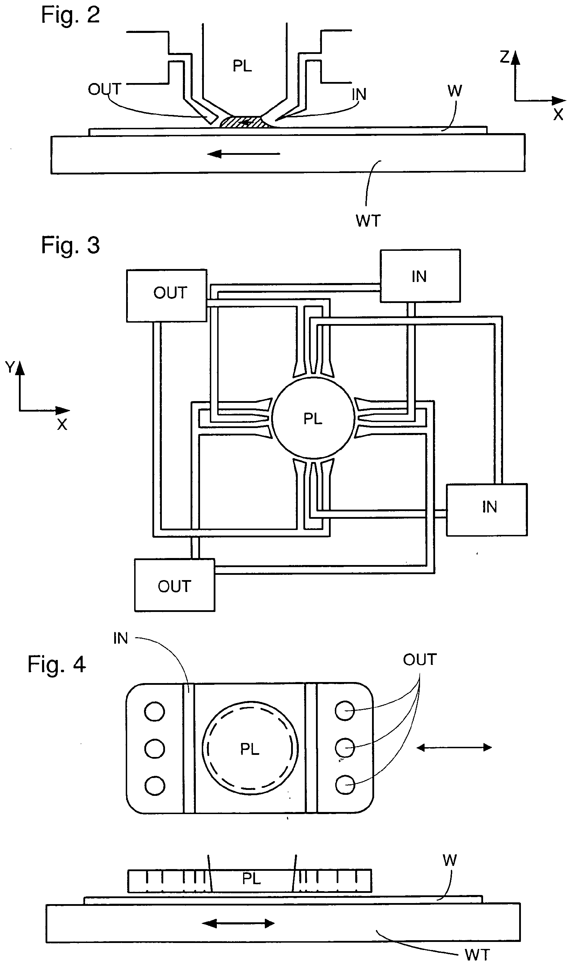

As illustrated in Figures 2 and 3, liquid is supplied by at least one inlet IN onto the substrate, preferably along the direction of movement of the substrate relative to the final element, and is removed by at least one outlet OUT after having passed under the projection system. That is, as the substrate is scanned beneath the element in a - X direction, liquid is supplied at the +X side of the element and taken up at the -X side. Figure 2 shows the arrangement schematically in which liquid is supplied via inlet IN and is taken up on the other side of the element by outlet OUT which is connected to a low pressure source. In the illustration of Figure 2 the liquid is supplied along the direction of movement of the substrate relative to the final element, though this does not need to be the case. Various orientations and numbers of in- and out-lets positioned around the final element are possible, one example is illustrated in Figure 3 in which four sets of an inlet with an outlet on either side are provided in a regular pattern around the final element.

Another solution which has been proposed is to provide the liquid supply system with a seal member which extends along at least a part of a boundary of the space between the final element of the projection system and the substrate table. Such a solution is illustrated in Figure 4. The seal member is substantially stationary relative to the projection system in the XY plane though there may be some relative movement in the Z direction (in the direction of the optical axis). A seal is formed between the seal member and the surface of the substrate. Preferably the seal is a contactless seal such as a gas seal. Such as system with a gas seal is disclosed in European Patent Application No. 03252955.4.

In European Patent Application No. 03257072.3 the idea of a twin or dual stage immersion lithography apparatus is disclosed. Such an apparatus is provided with two stages for supporting the substrate. Leveling measurements are carried out with a stage at a first position, without immersion liquid, and exposure is carried out with a stage at a second position, where immersion liquid is present. Alternatively, the apparatus has only one stage. EP-A1-1628330 belongs to the prior art according to Article 54(3) EPC, and discloses an immersion exposure apparatus wherein the image formation characteristic of the projection optical system is adjusted on the basis of the temperature distribution information of the immersion liquid measured by temperature sensors.

It is important to minimize temperature variations in components that influence the path of the imaging radiation. Thermal expansion and contraction of optical components such as lenses and mirrors can lead to distortions of the image reaching the substrate as can temperature induced variations in the refractive index of the immersion liquid. Control of component temperatures is normally possible by limiting the extent and proximity of dissipative processes, both electrical and mechanical, or of any other heatflux sources (i.e. sources that provide or absorb heat), and ensuring good thermal connection between components and high heat capacity elements. However, despite employing measures such as these with regard to optical elements, image distortions traceable to variations in temperature and/or in local beam intensity continue to be detected.

It is an object of the present invention to reduce image distortion due to temperature gradients in the substrate and immersion liquid.

The scope of the invention is defined in the appended claims.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc.

The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm).

### BRIEF DESCRIPTION OF THE DRAWINGS

Embodiments, including embodiments of the invention, will now be described, by way of example only, with reference to the accompanying schematic drawings in which corresponding reference symbols indicate corresponding parts, and in which:
- Figure 1 depicts a lithographic apparatus according to an embodiment ;
- Figures 2 and 3 depict a liquid supply system used in a prior art lithographic projection apparatus;
- Figure 4 depicts a liquid supply system according to another prior art lithographic projection apparatus;
- Figure 5 depicts the liquid supply system and seal member according to an embodiment ;
- Figure 6 depicts the flow rate adjustment device and liquid temperature adjustment device according to an embodiment ; and
- Figure 7 depicts a lithographic apparatus according to an embodiment, comprising a projection system compensator, patterned radiation beam distortion detector, temperature sensor and storage device.

In the Figures, corresponding reference symbols indicate corresponding parts.

### DETAILED DESCRIPTION

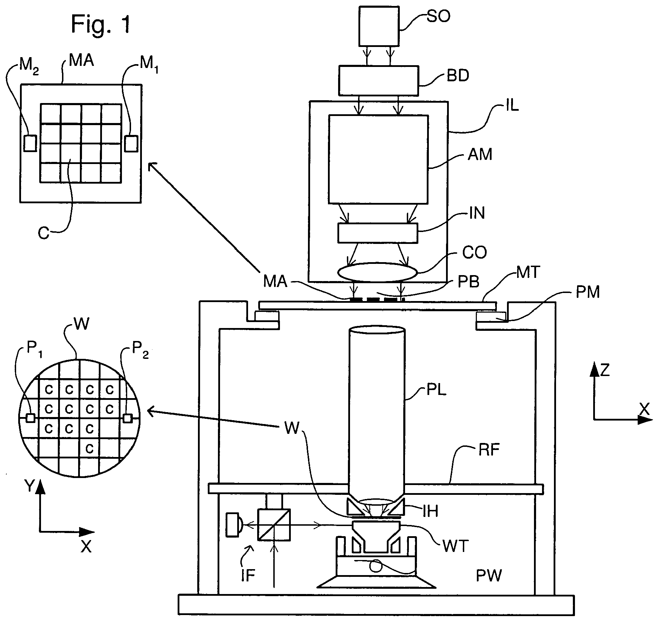

Figure 1 schematically depicts a lithographic apparatus according to one embodiment. The apparatus comprises:
- an illumination system (illuminator) IL configured to condition a radiation beam B (e.g. UV radiation or DUV radiation).
- a support structure (e.g. a mask table) MT constructed to support a patterning device (e.g. a mask) MA and connected to a first positioner PM configured to accurately position the patterning device in accordance with certain parameters;
- a substrate table (e.g. a wafer table) WT constructed to hold a substrate (e.g. a resist-coated wafer) W and connected to a second positioner PW configured to accurately position the substrate in accordance with certain parameters; and
- a projection system (e.g. a refractive projection lens system) PS configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask MA), which is held on the support structure (e.g., mask table MT), and is patterned by the patterning device. Having traversed the mask MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:
1. In step mode, the mask table MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the radiation beam is projected onto a target portion C (i.e. a single dynamic exposure). The velocity and direction of the substrate table WT relative to the mask table MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

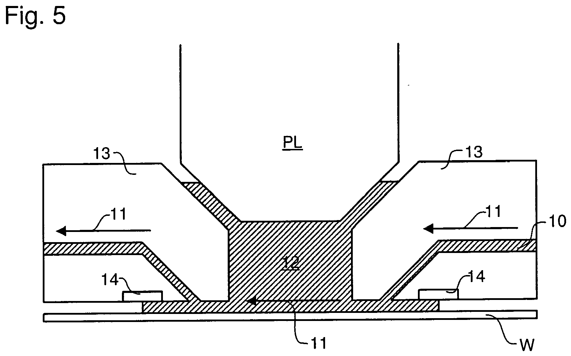

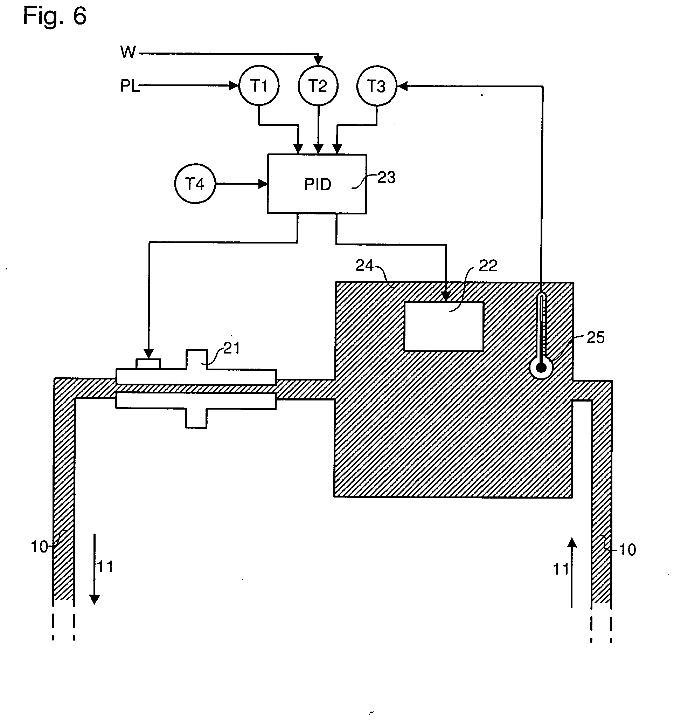

Figures 5 and 6 show the liquid supply system 10 and features 21, 22 and 23 of the temperature controller according to an embodiment. The projection system PL, substrate W and immersion liquid have temperature dependent properties that may influence the quality of the image written to the substrate W. Heatflux from various sources can lead to temperature offsets in one or more of these elements and even to temperature gradients if no counter-measures are employed. This possibility is exacerbated by the relatively low thermal conductance and heat capacity of the substrate (due both to the material used and the thin geometry). Temperature gradients lead to thermal expansion/contraction gradients that, depending on the element in question may distort the written image. This may be a particularly difficult problem when the temperature profile changes as the imaging beam moves relative to the substrate W, as may occur in the substrate itself, for example. In the case of the immersion liquid, localised hotspots or coldspots on the substrate W also lead to temperature gradients in the liquid, with liquid located close to the hotspots/coldspots being higher/lower in temperature than liquid located further away. Since the refractive index is generally temperature dependent, this will influence the path the imaging radiation takes through the liquid and will distort the image. By using a temperature controller that ensures not only the constancy of the projection system temperature but also that of the substrate W and immersion liquid, distortion of the image due to these factors can be reduced.

In the embodiment shown, the liquid supply system 10 supplies liquid to an imaging-field reservoir 12 between the projection lens PL and the substrate W. The liquid is preferably chosen to have a refractive index substantially greater than one meaning that the wavelength of the projection beam is shorter in the liquid than in air or a vacuum, allowing smaller features to be resolved. It is well known that the resolution of a projection system is determined, inter alia, by the wavelength of the projection beam and the numerical aperture of the system. The presence of the liquid may also be regarded as increasing the effective numerical aperture.

The reservoir 12 is bounded at least in part by a seal member 13 positioned below and surrounding the final element of the projection lens PL. The seal member 13 extends a little above the final element of the projection lens PL and the liquid level rises above the bottom end of the final element of the projection lens PL. The seal member 13 has an inner periphery that at the upper end closely conforms to the step of the projection system or the final element thereof and may, e.g., be round. At the bottom, the inner periphery closely conforms to the shape of the image field, e.g. rectangular but may be any shape.

Between the seal member 13 and the substrate W, the liquid can be confined to the reservoir by a contact-less seal 14, such as a gas seal formed by gas provided under pressure to the gap between the seal member 13 and the substrate W.

As has been discussed above, lithographic apparatuses are extremely sensitive to thermally induced changes to the physical properties of optical elements. These changes may include thermal expansion/contraction or changes in intrinsic properties such as refractive index. In an apparatus as complex as a typical lithography device, there will inevitably be a number of important heatflux sources that may contribute to temperature variations in critical areas. These sources may derive from dissipation arising in electrically driven devices, with or without moving parts, from variations in the external environment temperature, or from evaporation/condensation of fluids. An important source of heat stems from the absorption of imaging radiation by the substrate W (leading to overlay errors). This source may also heat the substrate table holding the substrate W and the immersion liquid via convection from the substrate. Bulk temperature increases may arise via this mechanism particularly for shorter wavelength radiation, such as 157 nm. Care may be taken to minimize heating caused within the apparatus and to prevent excessive variations in the external environment temperature but it is difficult to completely eradicate their effects particularly where dissipative heating occurs within the optical system itself.

These temperature variations may be relatively homogeneous leading to uniform changes in the image reaching the substrate W (such as uniform translation or magnification/shrinkage) or they may include contributions with a stronger spatial dependence. These latter variations may be considered more damaging because they may distort the image in a non-uniform way. The substrate W, for example, may be particularly vulnerable to such temperature variations since it is heated locally by the imaging radiation. In immersion lithography systems, the immersion liquid may also lead to temperature dependent optical properties because the refractive index of the liquid may vary with temperature.

Thermal management of these components is not amenable to the same methods used for standard optical elements. In the case of the substrate W, several factors are important. To begin with, the plate-like geometry suffers in two respects: firstly, each portion of the substrate W is in relatively poor thermal contact with the rest of the substrate W, so that heat disperses slowly, and secondly, the heat capacity of the substrate W per unit area will be reduced relative to a thicker slab. Both of these factors mean that a smaller amount of energy from the imaging radiation or other heatflux source will be necessary to locally heat or cool the substrate W to a given temperature. Furthermore, these problems are compounded by the fact that strict alignment tolerances and the required mobility of the substrate W greatly restrict the deployment of mechanical thermal connections to the substrate W. In the case of the immersion liquid, heat exchanged between the substrate W and the liquid tends to heat or cool the liquid in a non-uniform way by convective currents and the like stimulated by temperature induced density variations rather than by conduction. Within a stationary liquid, this process may happen slowly leading to substantial temperature (and thus refractive index) gradients within the liquid. The contact area between the liquid and the substrate is large so that heat may be exchanged efficiently between the two.

In the embodiments depicted in figures 5 and 6, the immersion liquid exchanges heat with the final element of the projection system PL and the substate W. In order to carry the heated or cooled liquid away, the liquid is made to flow (see arrows 11) through the imaging-field reservoir 12. It has been shown that convection tends to take place within a thin layer (approximately 300 µm) near the heated or cooled element in contact with the liquid, due to the effects of laminar flow. More effective heat exchange may be obtained by directing the flow towards the heated or cooled element in question (i.e. towards the substrate W in the embodiment shown in Figure 5). Particularly in the case where the temperature of the substrate W is of concern, it is also advantageous to position the immersion fluid outlet underneath the seal member 13 (as shown) and directed towards the substrate W. This arrangement helps to ensure relatively fresh immersion liquid near to the substrate W and minimizes the influx of excessively heated or cooled liquid that may be dragged into the imaging-field reservoir 12 at its lower boundaries (where the seal member 13 meets the substrate W).

Increasing the flow rate also improves the heat exchange between the liquid and elements with which it is in contact. In order to exploit this fact, the temperature controller may comprise a liquid flow rate adjustment device 21, the liquid flow rate being adjusted so as to optimize the difference between the common target temperature and the temperatures of the final element of the projection system PL, the substrate W and the liquid. Heat exchange with the liquid causes the temperatures of the final element of the projection system and the substrate to tend towards the temperature of the liquid. Increasing the flow rate of liquid over these elements increases the efficiency of this process. However, there may be a limit to how high the flow rate can reach without itself degrading imaging performance via turbulence or frictional heating. The flow rate controlling process may be carried out by varying the power of a pumping device, used to circulate the immersion liquid, or by changing the flow impedance of the liquid supply system 10 (by changing the cross-section of circulation channels forming part thereof, for example).

The temperature controller may also comprise a liquid temperature adjustment device 22, the temperature of the liquid flowing in the liquid supply system 10 being adjusted so as to optimize the difference between the common target temperature and the temperatures of the final element of the projection system PL, the substrate W and the liquid. Adjusting the temperature of the immersion liquid may be carried out inside a temperature adjustment reservoir 24, within which the temperature adjustment device 22 may be immersed along with thermometry 25. The temperature adjustment device 22 may act to cool the liquid, via a refrigeration device, towards the common target temperature or below to compensate for heating of the liquid elsewhere in the liquid supply system 10. Alternatively, the temperature adjustment device 22 may act to heat the liquid, for example by means of an electrical heater, towards the common target temperature or above. The action of the temperature adjustment device 22 may be realized by a water-to-water heat exchanger with a first input being to the immersion liquid and a second input to a supply of temperature controlled water. An advantage of this arrangement is that a supply of temperature controlled water may already be available from arrangements to service other parts of the scanner. The lens, for example, may already be cooled by a continuous flow of such water. Additionally, the temperature controlled water does not need to be chemically purified because it is recirculated.

The temperature controller may comprise a PID (Proportional-Integral-Differential) controller 23, a type of feedback controller, for achieving efficient convergence towards the common target temperature. The PID controller 23 may, for example, be arranged to ensure efficient convergence of one of more of the temperatures of the final element of the projection system, the substrate W and the liquid with the common target temperature (i.e. as quickly as possible and without overshoot).

The PID controller 23 controls the operation of the flow rate adjustment device 21 and/or the liquid temperature adjustment device 22, taking as input the temperature profile of the final element of the projection system T1 (preferably measured at a plurality of locations), the temperature profile of the substrate and substrate table T2 (preferably measured at a plurality of locations), the temperature profile of the liquid T3 (preferably measured at a plurality of locations), and the common target temperature T4. The operation of the PID controller 23 is not limited to the above context and may be used to regulate cooling processes throughout the scanner system.

The common target temperature may be set to a predetermined value. The predetermined value may be determined by the temperature at which the projection system has been calibrated.

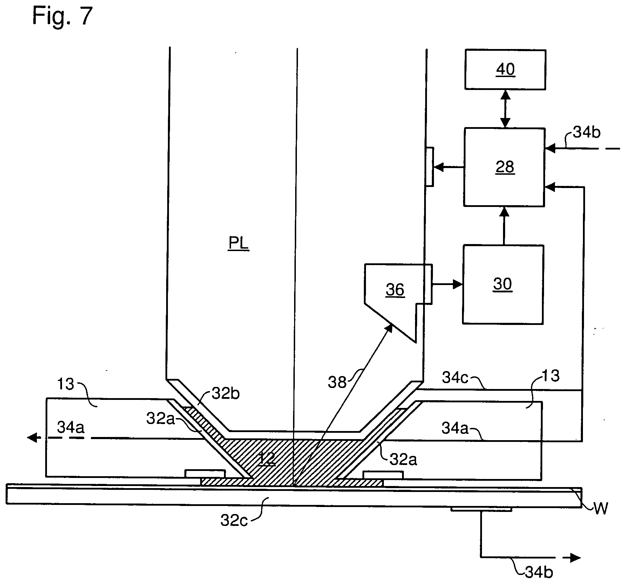

It has been described above how temperature variations in optically critical components, such as the final element of the projection system PL, the substrate W and the immersion liquid, can damage the imaging properties of the lithographic apparatus. Figure 7 depicts an alternative embodiment in which radiation beam distortions arising in this way are compensated using a projection system compensator 28, which is configured to adjust the optical properties of the projection system PL in response to a distortion in the pattern generated on the substrate W caused by a difference in temperature of at least one of the final element of the projection system PL, the substrate W and the liquid from a target temperature (such as a temperature at which the system has been calibrated). The distortion in the pattern generated on the substrate W may be caused either by a distortion in the patterned radiation beam, caused for example by variations in the temperature of the immersion liquid and/or final element of the projection system PL from the target temperature, or by temperature induced distortions of the substrate during exposure by the patterned radiation beam (which may or may not be distorted), distortion in the pattern generated on the substrate W occurring in this case when the distorted substrate regains its normal form.

The projection system compensator 28 can adjust the imaging properties of the projection system PL via one or more adjustable elements arranged therein (such as actuatable lenses or moveable mirrors). The effect that these adjustments will have on the form of the patterned radiation beam will be calibrated beforehand. This may be achieved by actuating each adjustable element over its operating range and analysing the form of the patterned radiation beam that emerges. Generally speaking, a radiation beam distortion can be expressed as an expansion in fundamental distortion modes (such as those expressed by Zernike series, for example). A calibration table may comprise matrices consisting of coefficients in such an expansion and settings for each adjustable element. If the adjustable elements are chosen to cover adequately the main types of distortion, their use in concert should enable compensation of most types of distortion that are likely to occur from temperature variations in the immersion liquid and the elements surrounding it.

The projection system compensator 28 may receive input from a patterned radiation beam distortion detector 30, which in the example embodiment illustrated is linked to an optical detector 36 within the projection system PL but alternative means may also be provided for this purpose. The optical detector 36 here is arranged to capture stray light 38 from the main patterned radiation beam that reflects from the substrate. This stray light may be analysed to determine the patterned beam distortion by the patterned beam distortion detector 30. This may be achieved, for example, by means of a comparator, which compares the detected radiation with a standard pattern that was obtained under control conditions. The extent of deviation from the standard pattern can be analyzed to characterize distortion of the patterned beam. This approach has the advantage of being a direct measure of temperature induced distortions. It is also applicable in-situ during normal operation of the lithographic apparatus and as such enables the projection system compensator to work dynamically in real time.

An alternative or additional approach is to measure the temperature profile of the elements likely to cause distortion of the patterned radiation beam and determine from calibration measurements or calculation what the resulting distortion is likely to be. The projection system compensator 28 may then compensate the projection system PL as described above without directly measuring the distortion itself. Figure 7 shows schematic arrangements of components 32a, 32b and 32c of a temperature sensor. These components 32a, 32b and 32c are depicted as layers and may, for example, each comprise one or a plurality of thermometers, which may be arranged to determine the temperature of at least a part of at least one of the final element of the projection system PL, the substrate W (and/or substrate table WT) and the liquid. Each of the components 32a, 32b and 32c are capable of communicating with the projection system compensator 28 via data transmission lines 34a, 34b and 34c. The amount of adjustment to apply to each of the adjustable elements of the projection system PL requires reference in this case to a second calibration table, which is stored in a storage device 40. In this case, the calibration data stores information derived from previous measurements recording the relationship between a given element temperature or temperature profile and the resulting distortion. Once the predicted distortion is established, the projection system compensator can operate as it would had the distortion information been forwarded from the patterned radiation beam distortion detector 30.

The process thus described may be carried out in real time to adapt dynamically to unexpected and/or uncontrollable temperature variations in the region around the imaging-field reservoir 12. As depicted, the projection system compensator 28 and the patterned radiation beam distortion detection device 30 may form a feedback loop, which may be arranged to keep radiation beam distortion within certain predefined limits. A PID controller similar to that employed to control the immersion liquid temperature may be incorporated to ensure stability and efficient convergence.

The above arrangements all have the advantage of being able to respond quickly to small variations in the temperature of critical elements. The system may usefully be used in combination with systems that minimize temperature variations themselves to achieve a high degree of temperature stability and imaging accuracy.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of or about 365, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described.

The present invention can be applied to any immersion lithography apparatus, in particular, but not exclusively, those types mentioned above.

The descriptions above are intended to be illustrative, not limiting. Thus, it will be apparent to one skilled in the art that modifications may be made to the invention as described without departing from the scope of the claims set out below. The invention is defined by the claims.

## Claims

1. An immersion lithographic apparatus configured for use with an illumination system (IL) configured to condition a radiation beam (B), and for use with a support (MT) constructed to support a patterning device (MA), the patterning device (MA) being capable of imparting the radiation beam (B) with a pattern in its cross-section to form a patterned radiation beam, the immersion lithographic apparatus comprising:
a substrate table (WT) constructed to hold a substrate (W);
a projection system (PL) configured to project the patterned radiation beam onto a target portion of the substrate (W);
a liquid supply system (10) arranged to at least partly fill a space between the final element of the projection system (PL) and the substrate (W) with liquid; and
a projection system compensator (28) comprising a temperature sensor (32a, 32b, 32c) arranged to measure the temperature of at least a part of at least one of the final element of the projection system (PL), the substrate (W) and the liquid; wherein the projection system compensator (28) is configured to adjust the optical properties of the projection system (PL) via one or more moveable mirrors arranged in said projection system in response to a distortion in the pattern generated on the substrate (W) caused by a difference in temperature of the temperature measured by the temperature sensor (32a, 32b, 32c) from a target temperature.

2. The immersion lithographic apparatus according to claim 1, wherein the projection system compensator (28) comprises a storage device (40) capable of storing a table of calibration data, said calibration data representing adjustments to be applied to the optical properties of the projection system in response to the measurement of the temperature sensor (32a, 32b, 32c).

3. A device manufacturing method comprising the steps of:
conditioning a radiation beam (B) with an illumination system (IL);
imparting the radiation beam (B) with a pattern of a patterning device (MA) in its cross-section to form a patterned radiation beam;
projecting with a projection system (PL) the patterned radiation beam onto a target portion of a substrate (W);
using a liquid supply system (10) to at least partly fill a space between the final element of the projection system (PL) and the substrate (W) with liquid;
using a temperature sensor (32a, 32b, 32c) of a projection system compensator (28) to measure the temperature of at least a part of at least one of the final element of the projection system (PL), the substrate (W) and the liquid; and
using the projection system compensator (28) to adjust the optical properties of the projection system (PL) via one or more moveable mirrors arranged in said projection system in response to a distortion in the pattern generated on the substrate (W) caused by a difference in temperature of the temperature measured by the temperature sensor (32a, 32b, 32c) from a target temperature

4. The device manufacturing method of claim 3, wherein the projection system compensator (28) comprises a storage device (40) capable of storing a table of calibration data, said calibration data representing adjustments to be applied to the optical properties of the projection system in response to the measurement of the temperature sensor (32a, 32b, 32c).

## Patentansprüche

1. Ein Immersionslithographiegerät, das zur Verwendung mit einem Beleuchtungssystem (IL), das konfiguriert ist, einen Strahlungsstrahl (B) zu konditionieren, und zur Verwendung mit einer Stütze (MT), die konstruiert ist, um eine Musteraufbringungsvorrichtung (MA) zu stützen, konfiguriert ist, wobei die Musteraufbringungsvorrichtung (MA) in der Lage ist, den Strahlungsstrahl (B) in seinem Querschnitt mit einem Muster zu versehen, um einen gemusterten Strahlungsstrahl zu bilden, wobei das Immersionslithographiegerät Folgendes beinhaltet:
einen Substrattisch (WT), der konstruiert ist, um ein Substrat (W) zu halten;
ein Projektionssystem (PL), das konfiguriert ist, den gemusterten Strahlungsstrahl auf einen Zielabschnitt des Substrats (W) zu projizieren;
ein Flüssigkeitszufuhrsystem (10), das angeordnet ist, um einen Raum zwischen dem Endelement des Projektionssystems (PL) und dem Substrat (W) mindestens teilweise mit Flüssigkeit zu füllen, und
einen Projektionssystemkompensator (28), der einen Temperaturfühler (32a, 32b, 32c) beinhaltet, welcher zum Messen der Temperatur von mindestens einem Teil von mindestens einem von dem Endelement des Projektionssystems (PL), dem Substrat (W) und der Flüssigkeit angeordnet ist;
wobei der Projektionssystemkompensator (28) konfiguriert ist, als Reaktion auf eine Verzerrung in dem auf dem Substrat (W) erzeugten Muster, bewirkt durch eine Temperaturdifferenz der von dem Temperaturfühler (32a, 32b, 32c) gemessenen Temperatur von einer Zieltemperatur, die optischen Eigenschaften des Projektionssystems (PL) über einen oder mehrere bewegliche Spiegel, die in dem Projektionssystem angeordnet sind, anzupassen.

2. Immersionslithographiegerät gemäß Anspruch 1, wobei der Projektionssystemkompensator (28) eine Speichervorrichtung (40) beinhaltet, die in der Lage ist, eine Tabelle von Kalibrierungsdaten zu speichern, wobei die Kalibrierungsdaten Anpassungen darstellen, die als Reaktion auf die Messung des Temperaturfühlers (32a, 32b, 32c) an den optischen Eigenschaften des Projektionssystems vorzunehmen sind.

3. Ein Verfahren zum Herstellen einer Vorrichtung, das die folgenden Schritte beinhaltet:
Konditionieren eines Strahlungsstrahls (B) mit einem Beleuchtungssystem (IL);
Versehen des Strahlungsstrahls (B) in seinem Querschnitt mit einem Muster einer Musteraufbringungsvorrichtung (MA), um einen gemusterten Strahlungsstrahl zu bilden;
Projizieren des gemusterten Strahlungsstrahls auf einen Zielabschnitt eines Substrats (W) mit einem Projektionssystem (PL);
Verwenden eines Flüssigkeitszufuhrsystems (10), um einen Raum zwischen dem Endelement des Projektionssystems (PL) und dem Substrat (W) mindestens teilweise mit Flüssigkeit zu füllen,
Verwenden eines Temperaturfühlers (32a, 32b, 32c) eines Projektionssystemkompensators (28) zum Messen der Temperatur von mindestens einem Teil von mindestens einem von dem Endelement des Projektionssystems (PL), dem Substrat (W) und der Flüssigkeit; und
Verwenden des Projektionssystemkompensators (28) zum Anpassen der optischen Eigenschaften des Projektionssystems (PL) über einen oder mehrere bewegliche Spiegel, die in dem Projektionssystem angeordnet sind, als Reaktion auf eine Verzerrung in dem auf dem Substrat (W) erzeugten Muster, bewirkt durch eine Temperaturdifferenz der von dem Temperaturfühler (32a, 32b, 32c) gemessenen Temperatur von einer Zieltemperatur.

4. Verfahren zum Herstellen einer Vorrichtung gemäß Anspruch 3, wobei der Projektionssystemkompensator (28) eine Speichervorrichtung (40) beinhaltet, die in der Lage ist, eine Tabelle von Kalibrierungsdaten zu speichern, wobei die Kalibrierungsdaten Anpassungen darstellen, die als Reaktion auf die Messung des Temperaturfühlers (32a, 32b, 32c) an den optischen Eigenschaften des Projektionssystems vorzunehmen sind.

## Revendications

1. Un appareil lithographique à immersion configuré pour être utilisé avec un système d'illumination (IL) configuré afin de conditionner un faisceau de rayonnement (B), et pour être utilisé avec un support (MT) construit afin de supporter un dispositif servant à conformer selon un motif (MA), le dispositif servant à conformer selon un motif (MA) étant capable de conférer au faisceau de rayonnement (B) un motif dans sa coupe transversale afin de former un faisceau de rayonnement à motif, l'appareil lithographique à immersion comprenant :
une table porte-substrat (WT) construite afin de porter un substrat (W) ;
un système de projection (PL) configuré afin de projeter le faisceau de rayonnement à motif sur une portion cible du substrat (W) ;
un système d'alimentation en liquide (10) agencé afin de remplir au moins en partie de liquide un espace entre l'organe final du système de projection (PL) et le substrat (W) ; et
un compensateur de système de projection (28) comprenant un capteur de température (32a, 32b, 32c) agencé afin de mesurer la température d'au moins une partie d'au moins un élément parmi l'organe final du système de projection (PL), le substrat (W) et le liquide ;
dans lequel le compensateur de système de projection (28) est configuré afin d'ajuster les propriétés optiques du système de projection (PL) par le biais d'un ou de plusieurs miroirs mobiles agencés dans ledit système de projection en réponse à une distorsion dans le motif généré sur le substrat (W) causée par une différence de température de la température mesurée par le capteur de température (32a, 32b, 32c) par rapport à une température cible.

2. L'appareil lithographique à immersion selon la revendication 1, dans lequel le compensateur de système de projection (28) comprend un dispositif de stockage (40) capable de stocker une table de données d'étalonnage, lesdites données d'étalonnage représentant des ajustements à appliquer aux propriétés optiques du système de projection en réponse à la mesure du capteur de température (32a, 32b, 32c).

3. Un procédé de fabrication de dispositif comprenant les étapes consistant :
à conditionner un faisceau de rayonnement (B) avec un système d'illumination (IL) ;
à conférer au faisceau de rayonnement (B) un motif d'un dispositif servant à conformer selon un motif (MA) dans sa coupe transversale afin de former un faisceau de rayonnement à motif ;
à projeter avec un système de projection (PL) le faisceau de rayonnement à motif sur une portion cible d'un substrat (W) ;
à utiliser un système d'alimentation en liquide (10) afin de remplir au moins en partie de liquide un espace entre l'organe final du système de projection (PL) et le substrat (W) ;
à utiliser un capteur de température (32a, 32b, 32c) d'un compensateur de système de projection (28) afin de mesurer la température d'au moins une partie d'au moins un élément parmi l'organe final du système de projection (PL), le substrat (W) et le liquide ; et
à utiliser le compensateur de système de projection (28) afin d'ajuster les propriétés optiques du système de projection (PL) par le biais d'un ou de plusieurs miroirs mobiles agencés dans ledit système de projection en réponse à une distorsion dans le motif généré sur le substrat (W) causée par une différence de température de la température mesurée par le capteur de température (32a, 32b, 32c) par rapport à une température cible.

4. Le procédé de fabrication de dispositif de la revendication 3, dans lequel le compensateur de système de projection (28) comprend un dispositif de stockage (40) capable de stocker une table de données d'étalonnage, lesdites données d'étalonnage représentant des ajustements à appliquer aux propriétés optiques du système de projection en réponse à la mesure du capteur de température (32a, 32b, 32c).
